Europäisches Patentamt

European Patent Office

Office européen des brevets

(19)

(11) EP 0 531 769 B1

(12) **EUROPÄISCHE PATENTSCHRIFT**

(45) Veröffentlichungstag und Bekanntmachung des Hinweises auf die Patenterteilung:
**19.05.1999 Patentblatt 1999/20**

(51) Int Cl.⁶: **H04M 9/08**, H03G 7/00, H04M 1/60

(21) Anmeldenummer: **92114205.5**

(22) Anmeldetag: **20.08.1992**

(54) **Schaltungsanordnung zur Dynamiksteuerung eines Sprachendgerätes**

Circuit arrangement for dynamic control of a speech communication terminal

Circuit pour contrôler dynamiquement un poste téléphonique à mains libres

(84) Benannte Vertragsstaaten:
**AT BE CH DE ES FR GB IT LI NL SE**

(30) Priorität: **10.09.1991 DE 4130045**

(43) Veröffentlichungstag der Anmeldung:
**17.03.1993 Patentblatt 1993/11**

(73) Patentinhaber: **ALCATEL**
**75008 Paris (FR)**

(72) Erfinder:
• **Walker, Michael**
  **W-7066 Baltmannsweiler 2 (DE)**
• **Heitkämper, Peter**
  **W-6112 Grosszimmern 2 (DE)**

(74) Vertreter: **Knecht, Ulrich Karl, Dipl.-Ing. et al**
**Alcatel**
**Intellectual Property Department, Stuttgart**
**Postfach 30 09 29**
**70449 Stuttgart (DE)**

(56) Entgegenhaltungen:
**EP-A- 0 299 507          EP-A- 0 364 312**
**EP-A- 0 364 383          DE-A- 3 332 305**

• **SIEMENS TELCOM REPORT Bd. 12, Nr. 3, Mai 1989, BERLIN & MUNIC, DE Seiten 90 - 93 , XP52796 W. KRAFFT 'Digitales Freisprechen: ISDN-Komfort freih ndig nutzen'**

## Beschreibung

Die Erfindung betrifft eine Schaltungsanordnung gemäß dem Oberbegriff des Patentanspruchs 1.

Eine solche Schaltungsanordnung ist aus der EP-A-0 290 952 bekannt. Hier ist der im Sendezweig befindliche Verstärker als Dynamik-Kompander ausgebildet, dessen Dynamik-Kompressorteil die Aufgabe hat, vom Mikrophon erzeugte Signalspannungen, die oberhalb eines vorgegebenen Wertes liegen, auf einen einheitlichen Signalpegel zu komprimieren und dessen Expanderteil die Aufgabe hat, diese Signalspannungen, sofern sie unterhalb des vorgegebenen Wertes liegen, zu expandieren. Die Ausgangsspannung des Sendezweiges weist dann eine in Fig. 2 der o.g. Druckschrift wiedergegebene nichtlineare Abhängigkeit von der Ausgangsspannung des Mikrophons auf, die sich zur Anpassung an unterschiedliche Einsatzbedingungen mittels einer Stelleinrichtung verändern läßt. Gemäß Fig. 6 der genannten Druckschrift läßt sich die zunächst in analoger Technik beschriebene Schaltungsanordnung auch in digitaler Technik realisieren. Hierzu werden Mikrophon und Lautsprecher über Analog-Digitalwandler an Sendezweig und Empfangszweig angeschlossen und die einzelnen Schaltungsbauelemente werden durch die entsprechenden digital arbeitenden Bauelemente ersetzt.

Es ist weiterhin ein Fernsprechendgerät mit Einrichtungen zur Geräuschunterdrückung bekannt, bei dem im Empfangspfad und im Sendepfad steuerbare Dämpfungsglieder vorhanden sind, die über eine Steuerbaugruppe im wesentlichen in Abhängigkeit vom Umgebungsgeräusch gesteuert werden, das von einem zusätzlichen Mikrofon aufgenommen wird, vgl. EP-A-0 299 507. Die Steuerung der Dämpfungsglieder erfolgt über die Steuerbaugruppe außerdem vom Sendepegel und vom Empfangspegel, wobei diese Anordnung allgemein als sprachgesteuerte Waage bekannt ist.

Die erstgenannte Schaltungsanordnung ist sowohl in analoger als auch in digitaler Ausführung wegen der Vielzahl der verwendeten Bauelemente recht aufwendig. Die zweitgenannte Schaltungsanordnung benötigt ein zweites Mikrofon, dessen Anordnung in einem Fernsprechendgerät mit konstruktiven Schwierigkeiten verbunden ist.

Es ist deshalb Aufgabe der Erfindung, eine Schaltungsanordnung der eingangs genannten Art anzugeben, die weniger Schaltbauelemente aufweist als die bekannten Schaltungsanordnungen.

Diese Aufgabe wird durch die Merkmale des Patentanspruchs 1 gelöst.

Durch den Einsatz des digitalen Signalprozessors können diskrete Schaltungen zur Realisierung der Kompressor- und Expanderfunktion entfallen. Es kann nahezu jede beliebige Kennlinie im Prozessor gespeichert und zur Ermittlung eines geeigneten Verstärkungsfaktors verwendet werden. Läßt sich die zu verwendende Kennlinie durch einfache mathematische Funktionen beschreiben, können die gesuchten Verstärkungsfaktoren jeweils simultan nach einem gespeicherten Programm berechnet werden. Besitzt die zu verwendende Kennlinie einen komplizierten Verlauf, kann sie in Tabellenform im Prozessor oder einem mit diesem verbundenen Speicher abgelegt werden, und die gesuchten Verstärkungsfaktoren können jeweils in der Tabelle aufgesucht und ausgegeben werden.

Es besteht die Möglichkeit, die der Ermittlung des Verstärkungsfaktors zugrundeliegende Kennlinie in der Verstärkungsfaktor-Einstellschaltung in Abhängigkeit des dem Sprachpegel überlagerten Geräuschpegels zu verschieben. Damit werden Geräuschanteile des Eingangspegels in den Expansionsbereich der die Dynamik-Kompanderfunktion nachbildenden Kennlinie verschoben, in dem ihnen ein niedriger Verstärkungsfaktor zugeordnet wird. Eine gewisse Trennung der Sprachanteile des Eingangspegels von dessen Geräuschanteilen wird hier durch Begrenzung der Amplitude des Mikrophon-Ausgangssignals erreicht. Es wird hierbei die Tatsache ausgenutzt, daß die Sprachanteile in der Regel eine größere Amplitude haben als Geräuschanteile. Eine noch bessere Trennung von Sprachanteilen und Geräuschanteilen kann durch Nichtberücksichtigen solcher Abtastwerte des Mikrophon-Ausgangssignals erreicht werden, deren Amplitude einen vorgegebenen Wert übersteigt.

Weiterbildungen der Schaltungsanordnung nach der Erfindung sind in den Unteransprüchen angegeben.

So betrifft Anspruch 2 die Bewertung des gleichgerichteten Abtastwerts des Ausgangssignals des Mikrofons mit Gewichtungsfaktoren.

Anspruch 3 ermöglicht die Zugrundelegung unterschiedlicher Zeitkonstanten bei der Gewinnung von Eingangspegel-Mittelwerten, abhängig vom Gradienten des Mikrophon-Ausgangssignals. Damit kann die Dynamiksteuerung z.B. so betrieben werden, daß sie einem Eingangspegelanstieg schneller folgt als einem Eingangspegelabfall.

Der Gegenstand des Anspruches 4 ermöglicht eine Verschiebung der der Ermittlung des Verstärkungsfaktors zugrundeliegenden Kennlinie abhängig vom Empfangssignal. Hiermit können durch ungünstige Raumverhältnisse bedingte Erhöhungen des Empfangspegels, die zu Rückkopplungserscheinungen führen können, ausgeregelt werden.

Anspruch 5 gibt eine Möglichkeit wieder, den Zugriff der verschiedenen Schaltungen, welche die der Ermittlung des Verstärkungsfaktors zugrundeliegende Kennlinie verschieben, auf die Verstärkungsfaktor-Einstellschaltung zu steuern.

Anspruch 6 betrifft eine Möglichkeit, die der Ermittlung des Verstärkungsfaktors zugrundeliegende Kennlinie manuell zu verschieben und hiermit die Rückhörlautstärke zu verändern.

Anspruch 7 schließlich sieht die Realisierung der Funktionen der verschiedenen, Eingangspegel-Mittelwerte liefernden Schaltungen sowie des Vergleichers durch den digitalen Signalprozessor vor.

Anhand von 3 Figuren sollen nun Ausführungsbeispiele der Schaltungsanordnung nach der Erfindung beschrieben und ihre Wirkungsweise erklärt werden.

Fig. 1     zeigt schematisch die Schaltungsanordnung nach der Erfindung mit einem als Dynamik-Kompander wirkenden digitalen Signalprozessor und diskreten Schaltungen für die Erzeugung der diesem zuzuführenden Steuersignale.

Fig. 2     zeigt eine Eingangspegel-Mittelwertschaltung ebenfalls in schematischer Darstellung.

Fig. 3     zeigt eine Lösung, bei der auch die Erzeugung der Steuersignale für den Dynamik-Kompander durch den digitalen Signalprozessor vorgenommen wird.

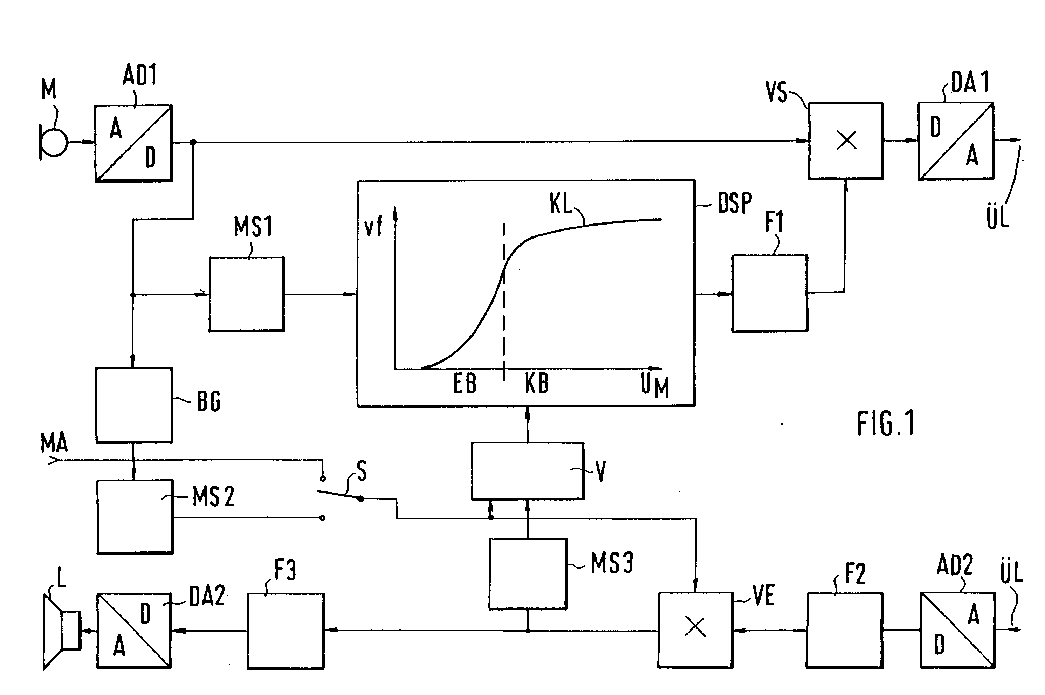

In Fig. 1 ist schematisch ein Sprachendgerät mit einem Sendezweig und einem Empfangszweig dargestellt. Der Sendezweig enthält ein Mikrophon M, einen ersten A/D-Wandler AD1, einen als Multiplizierer dargestellten Sendeverstärker VS und einen digitalen Signalprozessor DSP, der den Verstärkungsfaktor für den Sendeverstärker, abhängig von zwei Eingangspegel-Mittelwerten, anhand einer gespeicherten Kennlinie ermittelt. Ferner enthält der Sendezweig zwei Eingangspegel-Mittelwertschaltungen MS1, MS2, eine Empfangspegel-Mittelwertschaltung MS3, einen Begrenzer BG, einen Vergleicher V, eine nicht im einzelnen dargestellte manuelle Stellvorrichtung MA, die mit Betätigung eines Schalters S wirksam geschaltet werden kann, ein den ermittelten Verstärkungsfaktor glättendes erstes Filter F1 und einen ausgangsseitigen D/A-Wandler DA1, dessen Ausgang auf eine Übertragungsleitung ÜL führt.

Der Empfangszweig besitzt einen eingangsseitigen A/D-Wandler AD2, dessen Eingang mit der Übertragungsleitung ÜL verbunden ist, einen als Multiplizierer ausgebildeten Empfangsverstärker VE, ein diesem vorgeschaltetes Eingangsfilter F2, ein Ausgangsfilter F3 und einen ausgangsseitigen D/A-Wandler DA2, an dessen Ausgang ein Lautsprecher L angeschlossen ist.

Ein am Ausgang des Mikrophons M anstehendes analoges Signal, welches in der Regel sowohl Sprachsignalanteile als auch Geräuschsignalanteile enthält, wird im ersten A/D-Wandler in ein digitales Signal umgesetzt und einem Eingang des Sendeverstärkers VS zugeführt. Im Sendeverstärker VS, hier einem Multiplizierer, wird es mit einem Verstärkungsfaktor vf multipliziert und derart verstärkt über den Ausgangs-D/A-Wandler DA1 auf die Übertragungsleitung ÜL ausgegeben. Nach Durchgang durch ein an die Übertragungsleitung angeschlossenes gleichartiges Endgerät gelangt ein Teil des ausgegebenen Signals als Rückhörsignal auf den Eingang des Empfangszweiges. Es wird hier zunächst im A/D-Wandler AD2 digitalisiert, im digitalen Eingangsfilter F2 von außerhalb des Sprachbandes gelegenen Störfrequenzen befreit und dann im Empfangsverstärker VE auf eine zum Betrieb des Lautsprechers geeignete Höhe verstärkt. Das verstärkte Signal wird dann über ein Ausgangsfilter, durch das Geräteresonanzen gedämpft werden, einem Ausgangs-D/A-Wandler DA2 zugeführt, an dessen Ausgang der Lautsprecher L angeschlossen ist.

In dem bisher beschriebenen einfachen System ist die Verständigungsqualität aus vielen Gründen unbefriedigend. Im eingangs genannten Stand der Technik wurde deshalb dem Mikrophon ein Dynamik-Kompander nachgeschaltet, der in seinem Kompressionsbereich eine Verstärkung der zugeführten Signale auf einen einheitlichen Signalpegel und in seinem Expansionsbereich eine Abschwächung niedriger Pegel, wie z.B. Geräuschpegel bewirkt.

In der Schaltungsanordnung nach der Erfindung ist anstelle der die Kompanderfunktion ausführenden Schaltungen ein digitaler Signalprozessor DSP vorgesehen. Dieser enthält eine in Form eines Programmes oder in Form einer Tabelle gespeicherte Kennlinie, nach der er zu ihm zugeführten Eingangswerten $U_M$ Ausgangswerte vf liefert, die über das Filter F1 dem Sendeverstärker VS als Verstärkungsfaktor zugeführt werden.

Die Eingongswerte für den digitalen Signalprozessor werden in einer Eingangspegel-Mittelwertschaltung MS1 aus dem digitalisierten Mikrophon-Ausgangssignal gebildet.

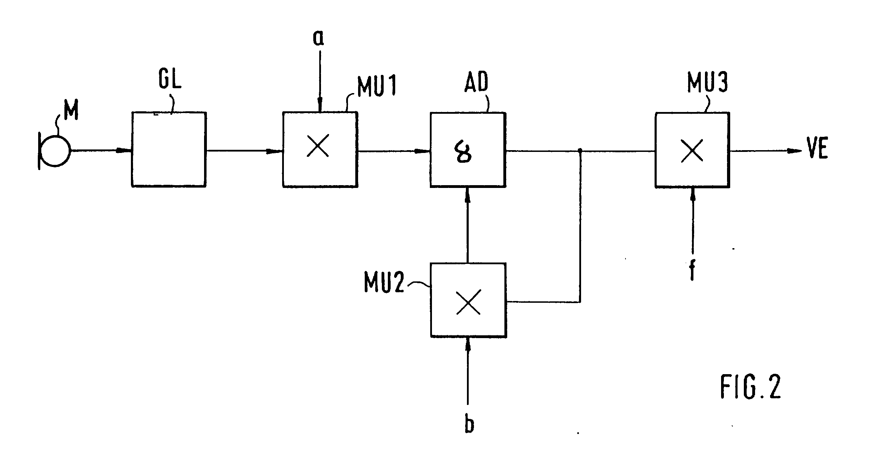

Diese Schaltung ist in Fig. 2 wiedergegeben. Sie enthält einen Gleichrichter, dem das (digital vorliegende) Mikrophon-Ausgangssignal zugeführt wird. Das gleichgerichtete Signal wird nun in einer ersten Multiplizierschaltung MU1 mit einem ersten Faktor a multipliziert und das Ergebnis einer Addierschaltung AD zugeführt. Eine in der Addierschaltung zuaddierte Größe wird aus dem Ausgangssignal der Addierschaltung durch Multiplikation mit einem zweiten Faktor b in einer zweiten Multiplizierschaltung MU2 gewonnen. Schließlich wird das Ausgangssignal der Addierschaltung noch in einer dritten Multiplizierschaltung MU3 mit einem Korrekfurfaktor f multipliziert. Das Ausgangssignal der dritten Multiplizierschaltung dient als Eingangswert $U_M$ in den digitalen Signalprozessor.

Die in Fig. 2 wiedergegebene Schaltung arbeitet wie folgt:

Das vom Mikrophon M kommende, digitalisierte Signal wird durch eine in der Figur nicht gezeigte Abtastschaltung mit einer vorgegebenen Frequenz abgetastet und gleichgerichtet. Letzteres bewirkt, daß am Ausgang des Gleichrichters der Betrag des jeweiligen Abtastwertes ansteht.

In der nachfolgenden Multiplizierschaltung MU1 wird der jeweilige Abtastwert mit einem ersten Gewichtungsfaktor a multipliziert und das Produkt der Addierschaltung AD zugeführt. In der Addierschaltung wird dem Produkt ein Altwert zuaddiert, der aus dem Ausgangssignal der Addierschaltuna durch Multiplikation mit einem zweiten Gewichtungsfaktor b in einer Multiplizierschaltung MU2 gewonnen wurde und somit Pegelinformation zeitlich vorausgegangener Abtastwerte enthält. Das Ausgangssignal der Addierschaltung AD wird in einer weiteren Multiplizierschaltung MU3 mit einem festen Korrekturfaktor f multipliziert und das Ergebnis der Verstärkungsfaktor-Einstellschaltung als Eingangspegel-Mittelwert zugeführt.

Der Eingangspegel-Mittelwert $U_e(k)$ läßt sich somit als Funktion zweier aufeinander folgender Abtastwerte auffassen.

$$U_e(k) = a \left| (U_e(k)) \right| + b\, U_e(k-1)$$

Hierbei ist $\left| U_e(k) \right|$ der Betrag des k-ten Abtastwertes, $U_e(k-1)$ der aufgrund des vorhergehenden Abtastwertes ermittelte unkorrigierte Eingangspegel-Mittelwert.

Werden die Konstanten a und b so gewählt, daß ihre Summe einen konstanten Wert, z.B. 1, ergibt, so läßt sich durch Vorgabe eines Wertes die Zeitkonstante der Schaltung festlegen. Überwiegt a, so reagiert die Schaltung schnell auf eine Änderung des Mikrophon-Ausgangssignals. Eine Vergrößerung von b hat ein trägeres Verhalten der Schaltung zufolge.

Werden unterschiedliche Wertepaare für a und b abgespeichert, so läßt sich leicht zwischen verschiedenen Zeitkonstanten umschalten. Auf einfache Weise kann dann z.B. erreicht werden, daß die Schaltung auf ansteigende Eingangspegel schnell und auf fallende Eingangspegel langsam reagiert. Es braucht dazu nur noch ein Vergleicher vorgesehen werden, der aufeinanderfolgende Abtastwerte daraufhin untersucht, in welcher Richtung jeweils eine Änderung erfolgt ist, und es muß eine steuerbare Spannungsquelle vorgesehen sein, die abhängig vom Ausgangssignal des Vergleichers verschiedene Wertepaare a und b an die Multiplizierschaltungen MU1 und MU2 anlegt.

Die in Fig. 1 dargestellte weitere Mittelwertschaltung MS2 entspricht der ersten Mittelwertschaltung in Aufbau und Funktion. Sie besitzt jedoch eine größere Zeitkonstante und ist einem Begrenzer BG nachgeschaltet, der hohe Mikrophon-Ausgangspegel, z.B. Sprachpegel, auf niedrige Werte begrenzt.

Das Ausgangssignal dieser Mittelwertschaltung gibt somit einen Pegel-Schätzwert für niedrige Pegel ab, die z.B. während Sprachpausen von Umgebungsgeräuschen verursacht werden.

Der Ausgang dieser Mittelwertschaltung wird über einen Schalter S und einen Vergleicher V der Verstärkungsfaktor-Einstellschaltung zugeführt, wo er z.B. die Verschiebung der zur Verstärkungsfaktor-Einstellung benutzten Kennlinie oder bei Vorhandensein zweier oder mehrerer abgespeicherter Kennlinien die Zugrundelegung einer anderen Kennlinie bewirkt. Auf diese Weise kann, z.B. in Sprachpausen, durch Verschiebung der in Fig. 1 dargestellten Kennlinie nach rechts der Expansionsbereich EB der Kennlinie so weit verlagert werden, daß er Geräuschpegel besser erfaßt. Diese werden damit noch weniger verstärkt. Anstelle des Begrenzers BG kann auch eine Schaltung treten, die einzelne Abtastwerte bewertet und unberücksichtigt läßt, wenn diese einen vorgegebenen Pegelwert übersteigen.

Da jede Verschiebung der in der Verstärkungsfaktor-Einstellschaltung abgespeicherten Kennlinie eine Änderung der Verstärkung im Sendezweig bewirkt, die sich auch bei der Rückhörlautstärke im Empfangszweig störend bemerkbar machen kann, ist als Verstärker VE im Empfangszweig ein Multiplizierer vorgesehen, dessen einem Eingang das Ausgangssignal der Mittelwertschaltung MS2 ebenfalls zugeführt wird. Auswirkungen von Änderungen der Signalverstärkung im Sendezweig werden damit im Empfangszweig kompensiert.

Die Empfangspegel-Mittelwertschaltung MS3, die in gleicher Weise aufgebaut sein kann wie die Mittelwertschaltungen MS1 und MS2, dient der Dämpfung von Raumkopplungserscheinungen bei ungünstiger Anordnung von Mikrophonen und Lautsprechern der verwendeten Endgeräte. Der Vergleicher V führt einen Maximumvergleich durch und schaltet jeweils den Ausgang derjenigen Mittelwertschaltung auf die Verstärkungsfaktor-Einstellschaltung durch, der den höheren Pegelwert besitzt.

Anstelle des Ausgangssignals der Eingangspegel-Mittelwertschaltung MS2 kann dem Vergleicher V und dem Empfangsverstärker VE auch, wie aus dem Stand der Technik bekannt, ein manuelles Stellsignal zugeführt werden. Dieses wird einer manuellen Stellvorrichtung MA entnommen und durch Umschalten des Schalters S an den Eingang des Vergleichers V und den Empfangsverstärker VE angelegt.

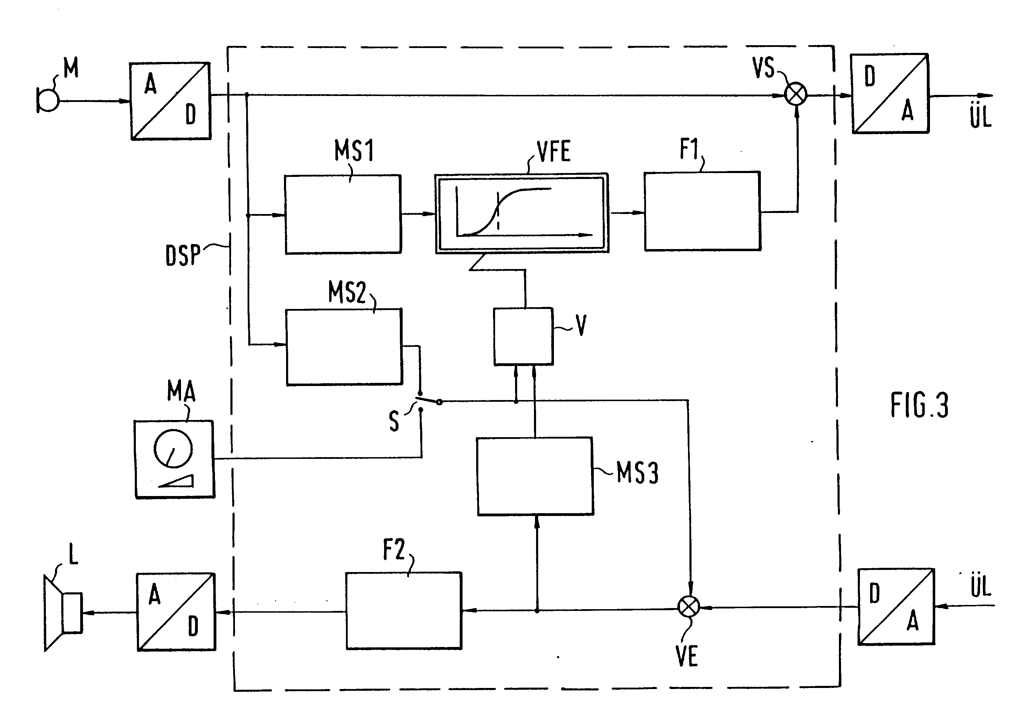

In Fig. 3 sind alle Schaltungen bis auf die A/D und D/A-Wandler und die manuelle Stellvorrichtung durch Funktionsblöcke innerhalb des digitalen Signalprozessors ersetzt. Diese Funktionsblöcke kennzeichnen Unterprogramme des Prozessors, die entsprechend der innerhalb des Prozessors DSP schematisch wiedergegebenen Schaltung zusammenwirken. Die in der im Zusammenhang mit Fig. 1 beschriebenen Schaltungsanordnung vom digitalen Signalprozessor ausgeführte Funktion ist in Fig. 3 mit Verstärkungs-Einstellschaltung VFE bezeichnet. Die Realisierung der im Zusammenhang mit Fig. 1 beschriebenen Schaltungen mit Hilfe eines leistungsfähigen digitalen Signalprozessors, z.B. dem Typ DSP 56 116 der Fa. Motorola, hat den Wegfall vieler Schaltungsbauteile zur Folge. Es werden damit Kosten und Störungsanfälligkeit weiter reduziert. Außerdem wird eine hohe Anpassungsfähigkeit der Endgeräte an die jeweiligen Einsatzbedingungen erreicht, da einzelne Unterprogramme leicht geändert oder besondere Ersatz-Unterprogramme aktiviert werden können. Bei Bedarf können noch weitere Schaltungsfunktionen, z.B. digitale Eingangsfilter im Empfangszweig, mittels des digitalen Signalprozessors realisiert werden.

**Patentansprüche**

1. Schaltungsanordnung zur Dynamiksteuerung eines Sprachendgerätes, das mindestens ein Mikrophon (M) und mindestens einen Lautsprecher (L) aufweist, in welchem das Mikrophon über einen Sendezweig und der Lautsprecher über einen Empfangszweig mit einem zu einem gleichartigen Gegen-Endgerät führenden Übertragungskanal (ÜL) verbunden sind und in welchem sowohl im Sendezweig als auch im Empfangszweig Verstärker (VS, VE) vorgesehen sind, deren Verstärkungsfaktoren abhängig vom Signalpegel geändert werden, **dadurch gekennzeichnet**, daß dem Sendezweig ein digitaler Signalprozessor (DSP) als Verstärkungsfaktor-Einstellschaltung (VFE) zugeordnet ist, dem ein aus dem Ausgangssignal des Mikrophons gewonnener Eingangspegel-Mittelwert ($U_M$) zugeführt wird, und der entsprechend einer als Programm oder Tabelle gespeicherten vorgegebenen Kennlinie (KL) zu jedem Eingangspegel-Mittelwert ($U_M$) einen Verstärkungsfaktor ermittelt und auf einen Steuereingang des im Sendezweig angeordneten Verstärkers (VS) ausgibt, daß zur Gewinnung des Eingangspegel-Mittelwerts eine erste Mittelwertschaltung (MS1) mit einer ersten Zeitkonstante vorgesehen ist, die das Ausgangssignal des Mikrophons (M) mehrfach abtastet, den jeweiligen Abtastwert gleichrichtet und das so gewonnene Signal der Verstärkungsfaktor-Einstellschaltung (VFE) als Eingangspegel-Mittelwert zugeführt wird und, daß zusätzlich zur ersten Mittelwertschaltung (MS1) eine gleichartige zweite Mittelwertschaltung (MS2) vorgesehen ist, die eine größere Zeitkonstante als die erste Mittelwertschaltung (MS1) besitzt und die ein durch einen Begrenzer in seiner Amplitude begrenztes Ausgangssignal des Mikrophons (M) mehrfach abtastet und hieraus einen zweiten Eingangspegel-Mittelwert gewinnt, daß der zweite Eingangspegel-Mittelwert zum einen der Verstärkungsfaktor-Einstellschaltung (VFE) zugeführt wird, wo er eine Verschiebung der vorgegebenen Kennlinie oder die Vorgabe einer anderen gespeicherten Kennlinie bewirkt und zum anderen dem im Empfangszweig angeordneten Verstärker (VE) zugeführt wird, in dem er eine der Änderung des Verstärkungsfaktors des im Sendezweig angeordneten Verstärkers (VS) entgegengesetzte Änderung des Verstärkungsfaktors bewirkt.

2. Schaltungsanordnung nach Anspruch 1, dadurch gekennzeichnet, daß der gleichgerichtete Abtastwert des Ausgangssignals des Mikrophons (M) mit einem ersten Gewichtungsfaktor (a) multipliziert und dem Ergebnis einen aus dem vorhergehenden Abtastwert gewonnenen Altwert zuaddiert, der durch Multiplikation eines zeitlich vorausgehenden Additionsergebnisses mit einem zweiten Gewichtungsfaktor (b) gewonnen wurde und daß das Additionsergebnis nach Multiplikation mit einem festen Korrekturfaktor (f) der Verstärkungsfaktor-Einstellschaltung (VFE) als Eingangspegel-Mittelwert zugeführt wird.

3. Schaltungsanordnung nach Anspruch 2, dadurch gekennzeichnet, daß die beiden Gewichtungsfaktoren in ihrer Summe einen konstanten Wert, vorzugsweise den Wert 1 ergeben, daß ein Vergleicher vorgesehen ist, der gleichgerichtete Abtastwerte mit aus zeitlich vorausliegenden Abtastwerten gewonnenen Eingangspegel-Mittelwerten vergleicht und daß das Verhältnis der beiden Gewichtungsfaktoren abhängig vom Vergleichsergebnis eingestellt wird.

4. Schaltungsanordnung nach Anspruch 1, dadurch gekennzeichnet, daß eine dritte gleichartige Mittelwertschaltung (MS3) vorgesehen ist, die das im Verstärker (VE) des Empfangszweiges verstärkte Empfangssignal mehrfach abtastet und einen Empfangspegel-Mittelwert gewinnt, der der Verstärkungsfaktor-Einstellschaltung (VFE) zugeführt wird, wo er eine Verschiebung der vorgegebenen Kennlinie oder die Vorgabe einer anderen gespeicherten Kennlinie bewirkt.

5. Schaltungsanordnung nach Anspruch 4, dadurch gekennzeichnet, daß ein Vergleicher (V) vorgesehen ist, der den von der zweiten Mittelwertschaltung (MS2) gelieferten zweiten Eingangspegel-Mittelwert mit dem Empfangspegel-Mittelwert vergleicht und den jeweils höheren Wert auf die Verstärkungsfaktor-Einstellschaltung (VFE) durchschaltet.

6. Schaltungsanordnung nach Anspruch 5, dadurch gekennzeichet, daß eine manuelle Stellvorrichtung (MA) zur Vorgabe eines eine Verschiebung der vorgegebenen Kennlinie (KL) oder die Vorgabe einer anderen gespeicherten Kennlinie (KL) in der Verstärkungsfaktor-Einstellschaltung (VFE) bewirkenden Steuerwertes vorgesehen ist, daß dieser Steuerwert gleichzeitig anstelle des zweiten Eingangspegel-Mittelwertes einerseits dem Vergleicher (V) und andererseits dem im Empfangszweig angeordneten Verstärker (VE) zugeführt wird, wo er eine der Änderung des Verstärkungsfaktors des im Sendezweig angeordneten Verstärkers (VS) entgegengesetzte Änderung des Verstärkungsfaktors bewirkt.

7. Schaltungsanordnung nach einem der vorstehenden Ansprüche, dadurch gekennzeichnet, daß anstelle einer oder aller Mittelwertschaltungen (MS1 ...MS3) vorbereitete Programme im digitalen Signalprozessor (DSP) oder einem zugeordneten Speicher vorhanden sind und daß der digitale Signalprozessor (DSP) die Funktionen dieser Schaltungen zusätzlich ausführt.

**Claims**

1. A circuit arrangement for the dynamic control of a speech terminal comprising at least one microphone (M) and at least one loudspeaker (L), in which the microphone is connected via a transmitting branch and the loudspeaker is connected via a receiving branch to a transmission channel (ÜL) leading to an opposite terminal of the same type, and in which amplifiers (VS, VE) are provided both in the transmitting branch and in the receiving branch, the gain factors of which amplifiers are changed as a function of the signal level, characterised in that the transmitting branch is assigned a digital signal processor (DSP) as gain factor adjusting circuit (VFE), to which an input level mean value $(U_M)$ obtained from the output signal of the microphone is supplied and which, in accordance with a predetermined characteristic (KL) stored in the form of a program or table, for each input level mean value $(U_M)$ determines a gain factor and emits said gain factor to a control input of the amplifier (VS) arranged in the transmitting branch, that for the acquisition of the input level mean value a first mean value circuit (MS1) with a first time constant is provided, which circuit (MS1) multiply samples the output signal of the microphone (M) and rectifies the respective sample value, the signal thus obtained being fed to the gain factor adjusting circuit (VFE) as input level mean value, and that in addition to the first mean value circuit (MS1) a second mean value circuit (MS2) of the same type is provided which has a larger time constant than the first mean value circuit (MS1) and which multiply samples an output signal of the microphone (M) limited in its amplitude by a limiter and acquires therefrom a second input level mean value, that the second input level mean value is fed on the one hand to the gain factor adjusting circuit (VFE), in which it displaces the preset characteristic or presets a different stored characteristic, and is fed on the other hand to the amplifier (VE) arranged in the receiving branch, in which it implements a change in the gain factor opposed to the change in the gain factor of the amplifier (VS) arranged in the transmitting branch.

2. A circuit arrangement according to Claim 1, characterised in that the rectified sample value of the output signal of the microphone (M) is multiplied by a first weighting factor (a) and to the result there is added an earlier value taken from the preceding sample value and obtained by multiplying an earlier addition result by a second weighting factor (b), and that after multiplication by a fixed correction factor (f) the addition result is fed to the gain factor adjusting circuit (VFE) as input level mean value.

3. A circuit arrangement according to Claim 2, characterised in that the sum of the two weighting factors yields a constant value, preferably the value 1, that a comparator is provided which compares rectified sample values with input level mean values obtained from earlier sample values, and that the ratio of the two weighting factors is adjusted as a function of the comparison result.

4. A circuit arrangement according to Claim 1, characterised in that a third mean value circuit (MS3) of the same type is provided, which circuit (MS3) multiply samples the received signal amplified in the amplifier (VE) of the receiving branch and acquires a receiving level mean value which is fed to the gain factor adjusting circuit (VFE) in which it displaces the preset characteristic or presets another stored characteristic.

5. A circuit arrangement according to Claim 4, characterised in that a comparator (V) is provided which compares the second input level mean value supplied by the second mean value circuit (MS2) with the receiving level mean value and in each case switches through the higher value to the gain factor adjusting circuit (VFE).

6. A circuit arrangement according to Claim 5, characterised in that a manual control device (MA) is provided for presetting a control value which displaces the preset characteristic (KL) or presets another stored characteristic (KL) in the gain factor adjusting circuit (VFE), that this control value, in place of the second input level mean value, is simultaneously fed on the one hand to the comparator (V) and on the other hand to the amplifier (VE) arranged in the receiving branch in which it implements a change in the gain factor opposed to the change in the gain factor of the amplifier (VS) arranged in the transmitting branch.

7. A circuit arrangement according to one of the preceding claims, characterised in that programs prepared in place of one or all of the mean value circuits (MS1 ...MS3) are provided in the digital signal processor (DSP) or an associated memory, and that the digital signal processor (DSP) additionally executes the functions of these circuits.

## Revendications

1. Mode de couplage pour la commande dynamique d'un terminal vocal présentant au moins un microphone (M) et au moins un haut-parleur (L), dans lequel le microphone est relié par une branche d'émission et le haut-parleur par une branche de réception à un canal de transmission (ÜL) menant à un terminal opposé du même type, et dans lequel, aussi bien dans la branche d'émission que dans la branche de réception, sont prévus des amplificateurs (VS, VE) dont les gains sont modifiés en fonction du niveau de signal, caractérisé en ce qu'un processeur de signaux numériques (DSP) est affecté à la branche d'émission en tant que circuit de réglage du gain (VFE), auquel est amenée une valeur moyenne des niveaux d'entrée ($U_M$) obtenue à partir du signal de sortie du microphone, et qui détermine pour chaque valeur moyenne des niveaux d'entrée ($U_M$) un gain selon une courbe caractéristique (KL) donnée mémorisée sous forme de programme ou de tableau, et le sort sur une entrée de commande de l'amplificateur (VS) disposé dans la branche d'émission, en ce que pour l'obtention de la moyenne de niveaux d'entrée, un premier circuit de valeur moyenne (MS1) est prévu avec une première constante de temps, qui balaie à plusieurs reprises le signal de sortie du microphone (M), redresse la valeur de balayage respective, et que le signal ainsi obtenu est amené au circuit de réglage du gain (VFE) comme une valeur moyenne des niveaux d'entrée, et en ce qu'en plus du premier circuit de valeur moyenne (MS1), un deuxième circuit de valeur moyenne de même type (MS2) est prévu qui possède une constante de temps supérieure à celle du premier circuit de valeur moyenne (MS1) et qui balaie à plusieurs reprises un signal de sortie du microphone (M) limité en amplitude par un limiteur et en obtient une deuxième valeur moyenne des niveaux d'entrée, en ce que la deuxième valeur moyenne des niveaux d'entrée est d'une part amenée vers un circuit de réglage du gain (VFE), où elle provoque un décalage de la courbe caractéristique donnée ou la spécification d'une autre courbe caractéristique mémorisée, et est amenée d'autre part à l'amplificateur (VE) disposé dans la branche de réception, où il provoque une modification opposée à la modification du gain de l'amplificateur (VS) disposé dans la branche d'émission.

2. Mode de couplage selon la revendication 1, caractérisé en ce que la valeur de balayage redressée du signal de sortie du microphone (M) est multipliée par un premier facteur de pondération (a) et additionne au résultat une ancienne valeur obtenue à partir de la valeur de balayage précédente, qui a été obtenue en multipliant un résultat d'addition antérieur par un deuxième facteur de pondération (b), et en ce que le résultat d'addition est amené au circuit de réglage du gain (VFE) après multiplication par un facteur de correction fixe (f) en tant que valeur moyenne des niveaux d'entrée.

3. Mode de couplage selon la revendication 2, caractérisé en ce que les deux facteurs de pondération produisent dans leur somme une valeur constante, de préférence la valeur 1, en ce qu'un comparateur est prévu qui compare les valeurs de balayage redressées à des valeurs moyennes des niveaux d'entrée obtenues à partir de valeurs de balayage antérieures, et en ce que le rapport des deux facteurs de pondération est réglé en fonction du résultat de comparaison.

4. Mode de couplage selon la revendication 1, caractérisé en ce qu'un troisième circuit de valeur moyenne de même type (MS3) est prévu, qui balaie à plusieurs reprises le signal de réception amplifié dans l'amplificateur (VE) de la branche de réception et obtient une valeur moyenne des niveaux d'entrée qui est amenée au circuit de réglage du gain (VFE), où elle provoque un décalage de la courbe caractéristique donnée ou la spécification d'une autre courbe caractéristique mémorisée.

5. Mode de couplage selon la revendication 4, caractérisé en ce qu'un comparateur (V) est prévu, qui compare la deuxième valeur moyenne des niveaux d'entrée fournie par le deuxième circuit de valeur moyenne (MS2) à la valeur moyenne des niveaux de réception et commute respectivement la valeur supérieure sur le circuit de réglage du gain (VFE).

6. Mode de couplage selon la revendication 5, caractérisé en ce qu'un dispositif de réglage manuel (MA) est prévu pour spécifier une valeur de commande provoquant un décalage de la courbe caractéristique (KL) ou la spécification d'une autre courbe caractéristique mémorisée (KL) dans le circuit de réglage du gain (VFE), en ce que cette valeur de commande est amenée simultanément au lieu de la deuxième valeur moyenne des niveaux d'entrée, d'une part au comparateur (V) et d'autre part à l'amplificateur (VE) disposé dans la branche de réception, où il provoque une modification du gain opposée à la modification du gain de l'amplificateur (VS) disposé dans la branche d'émission.

7. Mode de couplage selon l'une quelconque des revendications précédentes, caractérisé en ce qu'au lieu d'un ou de tous les circuits de valeur moyenne (MS1 ... MS3), des programmes préparés existent dans le processeur de signaux numériques (DSP) ou une mémoire associée, et en ce que le processeur de signaux numériques (DSP) exécute en plus les fonctions de ces circuits.

FIG.1

EP 0 531 769 B1

FIG.2

EP 0 531 769 B1

FIG.3